# EUROPÄISCHE PATENTANMELDUNG

(11) **EP 1 367 713 A2**
(43) Veröffentlichungstag der Anmeldung: **03.12.2003**
(21) Anmeldenummer: 03011368.2
(22) Anmeldetag: 19.05.2003
(51) Int. Cl.: H03H 1/02, H03H 3/00

(54) **Elektrisches Modul**

(30) Priorität: 29.05.2002 DE 10223998
(71) Anmelder: Vishay Electronic GmbH, 84034 Landshut (DE)
(72) Erfinder: Grieb, Theo, Dr., 84184 Tiefenbach (DE); Preisser, Maximilian, 84032 Altdorf (DE)
(74) Vertreter: Manitz, Finsterwald & Partner GbR

(57) **Zusammenfassung**

Ein elektrisches Modul umfasst einen Träger und mehrere auf einer Trägerseite integrierte elektrische Bauelemente, deren auf derselben Trägerseite angeordnete Anschlüsse zumindest teilweise als externe Kontakte vorgesehen sind, über die das Modul z.B. auf einer Leiterplatte kontaktierbar ist.

## Beschreibung

Die Erfindung betrifft ein elektrisches Modul sowie ein Verfahren zur Herstellung eines solchen elektrischen Moduls.

In einer Vielzahl von elektronischen Geräten werden zunehmend flache Baugruppen eingesetzt. Der Trend zu immer kleineren Abmessungen der Geräte wird u.a. durch die Verwendung von oberflächenmontierbaren Bauelementen (SMD = Surface Mounted Device) mittels einer speziellen Oberflächenmontagetechnik (SMT = Surface Mounted Technology) realisiert.

Es ist auch bereits bekannt, z.B. sogenannte Pi-Filter in Form von Planarfiltern aufzubauen (vgl. US 4,853,659).

Ein Problem bei den bisher bekannten elektrischen Modulen besteht u.a. darin, dass in der Regel durch den betreffenden Träger hindurchgehende Kontaktierungen und/oder Umkontaktierungen erforderlich sind.

Ziel der Erfindung ist es, ein elektrisches Modul zu schaffen, der möglichst kompakt ist und bei dem aufwendige und teure Durchkontaktierungen bzw. Umkontaktierungen vermieden werden.

Diese Aufgabe wird erfindungsgemäß gelöst durch ein elektrisches Modul mit einem Träger und mehreren auf einer Trägerseite integrierten elektrischen Bauelementen, deren auf derselben Trägerseite angeordnete Anschlüsse zumindest teilweise als externe Kontakte vorgesehen sind, über die das Modul kontaktierbar ist.

Aufwendige und entsprechend teure Durchkontaktierungen bzw. Umkontaktierungen entfallen.

Das elektrische Modul kann vorteilhafterweise als SMD-Modul ausgeführt sein.

Über die betreffenden Anschlüsse kann das elektrische Modul insbesondere auf einer Leiterplatte, einer gedruckten Schaltung und/oder der gleichen kontaktiert werden.

Der Träger kann insbesondere durch ein Keramiksubstrat, eine Dünnfilmkeramik oder eine Leiterplatte gebildet sein. Dabei wird vorzugsweise eine Dickschichtkeramik eingesetzt.

Bei einer bevorzugten praktischen Ausführungsform des elektrischen Moduls sind die elektrischen Bauelemente teilweise oder ausschließlich durch diskrete Bauelemente gebildet.

Die elektrischen Bauelemente können zumindest teilweise in unterschiedlichen Ebenen angeordnet sein.

Von Vorteil ist insbesondere auch, wenn die elektrischen Bauelemente auf der betreffenden Trägerseite eine symmetrische Anordnung bilden.

Eine bevorzugte praktische Ausführungsform des erfindungsgemäßen elektrischen Moduls zeichnet sich dadurch aus, dass die elektrischen Bauelemente zwei identische diskrete Bauelemente und ein planarisierbares Bauelement umfassen.

Die elektrischen Bauelemente können insbesondere ein Filter, vorzugsweise ein sogenanntes Pi-Filter bilden. Dabei können die elektrischen Bauelemente beispielsweise zwei Kondensatoren und einen Widerstand umfassen. Die beiden Kondensatoren können insbesondere als identische diskrete Bauelemente und der Widerstand beispielsweise als Dickschichtwiderstand vorgesehen sein. Zwischen dem Dickschichtwiderstand und den Kondensatoren kann eine Isolationsschicht vorgesehen sein.

Erfindungsgemäß wird die eingangs genannte Aufgabe überdies gelöst durch ein Verfahren zur Herstellung eines elektrisches Moduls, bei dem auf eine Seite eines Trägers mehrere elektrische Bauelemente aufgebracht und die auf derselben Trägerseite angeordneten Anschlüsse dieser elektrischen Bauelemente zumindest teilweise als externe Kontakte zur Kontaktierung des Moduls verwendet werden.

Dabei wird das Modul vorzugsweise wieder als SMD-Modul ausgeführt. In diesem Fall wird der Träger bzw. das Keramiksubstrat vorteilhafterweise als Ansaugfläche für die SMD-Bestückung verwendet. Die durch die betreffenden Anschlüsse der elektrischen Bauelemente gebildeten externen Kontakte können insbesondere als Lötkontakte verwendet werden.

Weitere vorteilhafte Ausgestaltungen des erfindungsgemäßen Verfahrens sind in den Unteransprüchen angegeben.

Es ist somit insbesondere eine Integration konventioneller Bauelemente zu einem Modul auf Hybridebene möglich. Die Kontaktierung des beispielsweise ein Pi-Filter bildenden Moduls kann über die Bauelementanschlüsse erfolgen. Der Träger oder die Basisplatine, die beispielsweise durch eine Hybridkeramik gebildet sein kann, kann als Ansaugfläche für die SMD-Bestückung verwendet werden.

Es kann beispielsweise ein Pi-Filter als SMD-Standardbauelement verwirklicht werden. Kostspielige Durchkontaktierungen bzw. Umkontaktierungen entfallen. Durch die Verwendung des Trägers oder Basissubstrats als Ansaugfläche beispielsweise bei einer Pick& Place-Bestückung ergeben sich gute SMD-Eigenschaften. Durch die Verwendung der Anschlüsse der diskreten Komponenten als externe Lötkontakte wird eine gute Lötbarkeit des Moduls erreicht.

Die erfindungsgemäße Aufbautechnik ist generell beispielsweise bei Modulen einsetzbar, die sich aus zwei in der Höhe identischen diskreten Bauelementen mit in zwei Richtungen kontaktierbaren Kontakten sowie einem planarisierbaren Bauelement zusammensetzen. Dabei ist insbesondere ein Einsatz zur Herstellung passiv integrierter Pi-Filter von Vorteil.

Unter Anwendung der erfindungsgemäßen Aufbautechnik kann somit beispielsweise ein Pi-Filter-Bauelement für einen ESD (Electrostatic Discharge)-Schutz sowie einen Überspannungsschutz bei Lastabwurf (Load Dump Protection) verwirklicht werden.

Die Erfindung wird im Folgenden anhand eines Ausführungsbeispiels unter Bezugnahme auf die Zeichnung näher erläutert; in dieser zeigen:
- Fig. 1: das Schaltbild eines zwei Kondensatoren sowie einen Widerstand umfassenden Pi-Filters,
- Fig. 2: eine schematische Darstellung eines erfindungsgemäßen elektrischen Moduls zur Verwirklichung eines Pi-Filters gemäß Fig. 1,
- Fig. 3: eine schematische Seitenansicht des elektrischen Moduls gemäß Fig. 2 und
- Fig. 4: eine schematische Seitenansicht des elektrischen Moduls gemäß Fig. 2 nach erfolgter Kontaktierung auf einer Leiterplatte.

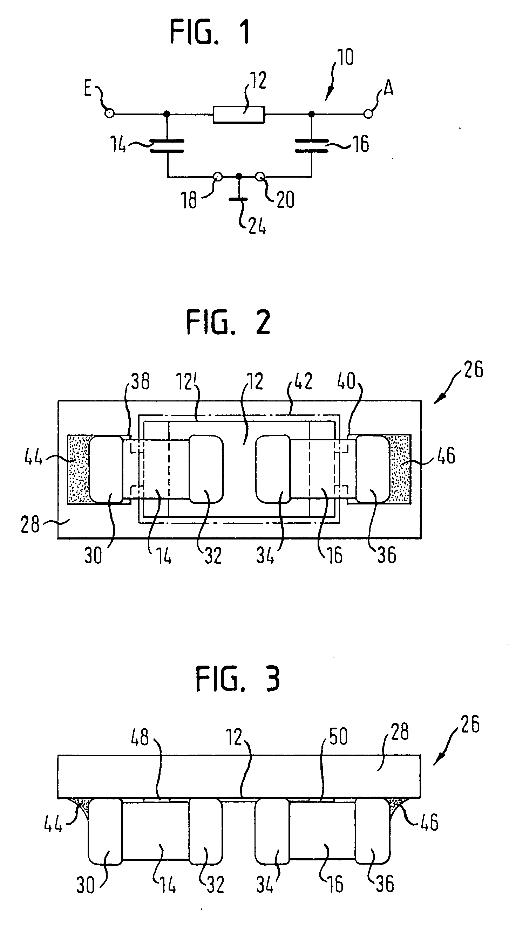

Fig. 1 zeigt das Schaltbild eines Tiefpass-Filters 10 in der Anordnung eines sogenannten Pi-Filters mit einem elektrischen Widerstand 12 und zwei Kondensatoren 14, 16.

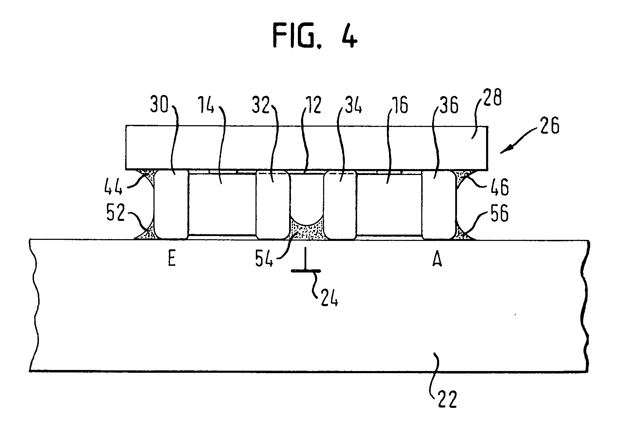

Dabei ist der erste Kondensator 14 auf einer Seite mit einer Eingangsklemme E und der zweite Kondensator 16 auf einer Seite mit einer Ausgangsklemme A des Filters 10 verbunden. Zwischen diese beiden Klemmen E, A ist der Widerstand 12 geschaltet. Die auf der anderen Seite der beiden Kondensatoren 14, 16 vorgesehenen Anschlüsse 18, 20 werden bei der Montage und Kontaktierung des Filters 10 auf einer Leiterplatte 22 (vgl. Fig. 4) beispielsweise mit Masse 24 verbunden.

Ein solches Filter 10 kann beispielsweise in einer Eingangsstufe eines betreffenden elektrischen Geräts vorgesehen sein.

Fig. 2 zeigt in schematischer Darstellung eine beispielhafte Ausführungsform eines erfindungsgemäßen elektrischen Moduls 26 zur Verwirklichung eines Pi-Filters gemäß Fig. 1.

Das elektrische Modul 26 umfasst einen Träger 28, der beispielsweise durch ein Keramiksubstrat und insbesondere eine Dickschichtkeramik gebildet sein kann.

Die betreffenden elektrischen Bauelemente 12 - 16 sind auf einer der beiden Trägerseiten integriert. Dazu ist auf dem Träger 28 zunächst ein Dickschichtwiderstand 12' aufgebracht. Zumindest teilweise über diesem Dickschichtwiderstand 12' sind die beiden Kondensatoren 14, 16 aufgebracht, die an ihren beiden Enden jeweils mit einer Metallisierung 30 - 36 versehen sind.

Wie anhand der Fig. 2 zu erkennen ist, liegen die die Metallisierung 30 bzw. die Metallisierung 36 aufweisenden Enden der Kondensatoren 14, 16 seitlich außerhalb des Bereichs des Dickschichtwiderstands 12'. Die betreffenden Kondensatorenden sind jeweils über eine Dickschichtleiterbahn 38 bzw. 40 mit einem jeweiligen Ende des Dickschichtwiderstandes 12' verbunden. Die betreffenden Metallisierungen 30, 36 bilden gleichzeitig dem Eingang E bzw. dem Ausgang A (vgl. Fig. 1) entsprechende Anschlüsse des elektrischen Moduls 26.

Die mit den Metallisierungen 32, 34 versehenen inneren Enden der Kondensatoren 14, 16 liegen über dem Dickschichtwiderstand 12', wobei zwischen diesen Kondensatorenden und dem Dickschichtwiderstand 12' eine Passivierungs- oder Isolationsschicht 42 vorgesehen ist. Die an den inneren Enden der Kondensatoren 14, 16 vorgesehenen Metallisierungen 32, 34 entsprechen den in der Fig. 1 gezeigten Anschlüssen 18, 20, die beim Kontaktieren des elektrischen Moduls 26 auf der Leiterplatte 22 (vgl. Fig. 4) beispielsweise mit Masse 24 verbindbar sind.

Wie insbesondere auch anhand der Fig. 3 und 4 erkennbar ist, können die Metallisierungen 30, 36 der beiden Kondensatoren 14, 16 in den Bereichen 44, 46 mit den Dickschichtleiterbahnen 38, 40 elektrisch verbunden sein. Überdies können die Kondensatoren 14, 16 beispielsweise an den Stellen 48, 50 mittels eines Klebers am Träger 28 fixiert sein.

Die mit den Metallisierungen 30 - 36 versehenen Kondensatorenden bilden gleichzeitig die Anschlüsse, über die das elektrische Modul 26 auf der Leiterplatte 22 kontaktierbar ist. Wie anhand der Fig. 2 bis 4 zu erkennen ist, sind diese Anschlüsse 30 - 36 auf derselben Trägerseite wie die elektrischen Bauelemente 12 - 16 vorgesehen. Durchkontaktierungen bzw. Umkontaktierungen entfallen somit.

Das elektrische Modul 26 kann somit insbesondere als SMD-Modul ausgeführt sein, der über die betreffenden Anschlüsse 30 - 36, die als externe Kontakte dienen, auf der Leiterplatte 22 insbesondere wieder durch Löten kontaktierbar ist. Die betreffenden Lötstellen sind in der Fig. 2 mit "52 - 56" bezeichnet. Über die Lötstelle 54 werden die innen liegenden Kondensatorenden z.B. mit Masse 24 verbunden werden. Über die Lötstellen 52, 56 erfolgt die Kontaktierung des Eingangs E bzw. des Ausgangs A des elektrischen Moduls 26.

Wie anhand der Fig. 2 bis 4 zu erkennen ist, bilden die elektrischen Bauelemente 12 - 16 auf der betreffenden Trägerseite eine symmetrische Anordnung. Dabei sind im vorliegenden Fall zwei in der Höhe identische diskrete Kondensatoren 14, 16 und ein planarisierbarer Widerstand 12, gebildet durch den Dickschichtwiderstand 12', vorgesehen.

Der Träger 28 kann als Ansaugfläche für die SMD-Bestückung verwendet werden. Die durch die betreffenden Anschlüsse 30 - 36 der elektrischen Bauelemente 12 - 16 gebildeten externen Kontakte können insbesondere als Lötkontakte verwendet werden.

### Bezugszeichenliste

- 10: Filter, Pi-Filter
- 12: elektrisches Bauelement, Widerstand
- 12': Dickschichtwiderstand
- 14: elektrisches Bauelement, Kondensator
- 16: elektrisches Bauelement, Kondensator
- 18: Anschluss
- 20: Anschluss
- 22: Leiterplatte
- 24: Masse
- 26: elektrisches Modul
- 28: Träger, Keramiksubstrat
- 30: Anschluss, Metallisierung
- 32: Anschluss, Metallisierung
- 34: Anschluss, Metallisierung
- 36: Anschluss, Metallisierung
- 38: Dickschichtleiterbahn
- 40: Dickschichtleiterbahn
- 42: Passivierungsschicht, Isolationsschicht
- 44: Lötbereich
- 46: Lötbereich
- 48: Klebstelle
- 50: Klebstelle
- 52: Lötbereich
- 54: Lötbereich
- 56: Lötbereich

- A: Ausgangsklemme
- E: Eingangsklemme

## Patentansprüche

1. Elektrisches Modul (26) mit einem Träger (28) und mehreren auf einer Trägerseite integrierten elektrischen Bauelementen (12 - 16), deren auf derselben Trägerseite angeordnete Anschlüsse (30 - 36) zumindest teilweise als externe Kontakte vorgesehen sind, über die der Modul (26) kontaktierbar ist.

2. Elektrisches Modul nach Anspruch 1,
**dadurch gekennzeichnet,**
**dass** es als SMD-Modul ausgeführt ist.

3. Elektrisches Modul nach Anspruch 1 oder 2,
**dadurch gekennzeichnet,**
**dass** es über die betreffenden Anschlüsse (30 - 36) auf einer Leiterplatte (22), einer gedruckten Schaltung und/oder dergleichen kontaktierbar ist.

4. Elektrisches Modul nach einem der vorhergehenden Ansprüche,
**dadurch gekennzeichnet,**
**dass** der Träger (28) durch ein Keramiksubstrat, eine Dünnfilmkeramik oder eine Leiterplatte gebildet ist.

5. Elektrisches Modul nach Anspruch 4,
**dadurch gekennzeichnet,**
**dass** der Träger (28) durch eine Dickschichtkeramik gebildet ist.

6. Elektrisches Modul nach einem der vorhergehenden Ansprüche,
**dadurch gekennzeichnet,**
**dass** die elektrischen Bauelemente (12 - 16) zumindest teilweise durch diskrete Bauelemente gebildet sind.

7. Elektrisches Modul nach einem der vorhergehenden Ansprüche,
**dadurch gekennzeichnet,**
**dass** die elektrischen Bauelemente (12 - 16) zumindest teilweise in unterschiedlichen Ebenen angeordnet sind.

8. Elektrisches Modul nach einem der vorhergehenden Ansprüche,
**dadurch gekennzeichnet,**
**dass** die elektrischen Bauelemente (12 - 16) auf der betreffenden Trägerseite eine symmetrische Anordnung bilden.

9. Elektrisches Modul nach einem der vorhergehenden Ansprüche,
**dadurch gekennzeichnet,**
**dass** die elektrischen Bauelemente (12 - 16) zwei in der Höhe identische diskrete Bauelemente (14, 16) und ein planarisierbares Bauelement (12) umfassen.

10. Elektrisches Modul nach einem der vorhergehenden Ansprüche,
**dadurch gekennzeichnet,**
**dass** die elektrischen Bauelemente (12 - 16) ein Filter bilden.

11. Elektrisches Modul nach Anspruch 10,
**dadurch gekennzeichnet,**
**dass** die elektrischen Bauelemente (12 - 16) ein Pi-Filter bilden.

12. Elektrisches Modul nach Anspruch 10 oder 11,
**dadurch gekennzeichnet,**
**dass** die elektrischen Bauelemente (12 - 16) zwei Kondensatoren (14, 16) und einen Widerstand (12) umfassen.

13. Elektrisches Modul nach Anspruch 12,
**dadurch gekennzeichnet,**
**dass** die beiden Kondensatoren (14, 16) als in der Höhe identische diskrete Bauelemente und der Widerstand (12) als Dickschichtwiderstand (12') vorgesehen sind.

14. Elektrisches Modul nach Anspruch 13,
**dadurch gekennzeichnet,**
**dass** zwischen dem Dickschichtwiderstand (12') und den Kondensatoren (14, 16') eine Isolationsschicht (42) vorgesehen ist.

15. Verfahren zur Herstellung eines elektrisches Moduls (26), bei dem auf eine Seite eines Trägers (28) mehrere elektrische Bauelemente (12 - 16) aufgebracht und die auf derselben Trägerseite angeordneten Anschlüsse (30 - 36) dieser elektrischen Bauelemente (12 - 16) zumindest teilweise als externe Kontakte zur Kontaktierung des Moduls (26) verwendet werden.

16. Verfahren nach Anspruch 15,
**dadurch gekennzeichnet,**
**dass** das Modul (26) als SMD-Modul ausgeführt wird.

17. Verfahren nach Anspruch 16,
**dadurch gekennzeichnet,**
**dass** der Träger (28) als Ansaugfläche für die SMD-Bestückung verwendet wird.

18. Verfahren nach einem der vorhergehenden Ansprüche,
**dadurch gekennzeichnet,**
**dass** die durch die betreffenden Anschlüsse (30 - 36) der elektrischen Bauelemente (12 - 16) gebildeten externen Kontakte als Lötkontakte verwendet werden.

19. Verfahren nach einem der vorhergehenden Ansprüche,
**dadurch gekennzeichnet,**
**dass** das Modul (26) über die betreffenden Anschlüsse (30 - 36) auf einer Leiterplatte (22), einer gedruckten Schaltung und/oder dergleichen kontaktiert wird.

20. Verfahren nach einem der vorhergehenden Ansprüche,
**dadurch gekennzeichnet,**
**dass** der Träger (28) durch ein Keramiksubstrat gebildet wird.

21. Verfahren nach Anspruch 20,
**dadurch gekennzeichnet,**
**dass** der Träger (28) durch eine Dickschichtkeramik gebildet wird.

22. Verfahren nach einem der vorhergehenden Ansprüche,
**dadurch gekennzeichnet,**
**dass** die elektrischen Bauelemente (12 - 16) zumindest teilweise durch passive Bauelemente gebildet werden.

23. Verfahren nach einem der vorhergehenden Ansprüche,
**dadurch gekennzeichnet,**
**dass** die elektrischen Bauelemente (12 - 16) zumindest teilweise in unterschiedlichen Ebenen angeordnet werden.

24. Verfahren nach einem der vorhergehenden Ansprüche,
**dadurch gekennzeichnet,**
**dass** auf der betreffenden Trägerseite eine symmetrische Anordnung von elektrischen Bauelementen (12 - 16) gebildet wird.

25. Verfahren nach einem der vorhergehenden Ansprüche,
**dadurch gekennzeichnet,**
**dass** die elektrischen Bauelemente (12 - 16) zwei in der Höhe identische diskrete Bauelemente (14, 16) und ein planarisierbares Bauelement (12) umfassen.

26. Verfahren nach einem der vorhergehenden Ansprüche,
**dadurch gekennzeichnet,**
**dass** mit den elektrischen Bauelementen (12 - 16) ein Filter gebildet wird.

27. Verfahren nach Anspruch 26,
**dadurch gekennzeichnet,**
**dass** mit den elektrischen Bauelementen (12 - 16) ein Pi-Filter gebildet wird.

28. Verfahren nach Anspruch 26 oder 27,
**dadurch gekennzeichnet,**
**dass** die elektrischen Bauelemente (12 - 16) zwei Kondensatoren (14, 16) und einen Widerstand (12) umfassen.

29. Verfahren nach Anspruch 28,
**dadurch gekennzeichnet,**
**dass** der Widerstand (12) durch einen Dickschichtwiderstand (12') gebildet wird und als Kondensatoren (14, 16) in der Höhe identische diskrete Bauelemente verwendet werden.

30. Verfahren nach Anspruch 29,
**dadurch gekennzeichnet,**
**dass** zwischen dem Dickschichtwiderstand (12') und den Kondensatoren (14, 16) eine Isolationsschicht (42) gebildet wird.
